# EUROPEAN PATENT SPECIFICATION

(11) **EP 2 789 097 B1**
(45) Date of publication and mention of the grant of the patent: **19.04.2017**
(21) Application number: 12785932.0
(22) Date of filing: 18.05.2012
(51) Int. Cl.: H03F 3/04, G05F 1/00, H03F 1/30, H03F 3/195, H03F 3/72

(54) **FEEDFORWARD ACTIVE DECOUPLING**
AKTIVE VORWÄRTSENTKOPPLUNG
DÉCOUPLAGE ACTIF AVEC ACTION ANTICIPATRICE

(30) Priority: 18.05.2011 US 201113110769
(43) Date of publication of application: 15.10.2014
(73) Proprietor: Texas Instruments Incorporated, Dallas, TX 75265-5474 (US)
(72) Inventor: GINSBURG, Brian, P., Allen TX 75013 (US); RENTALA, Vijay, B., Plano TX 75025 (US); RAMASWAMY, Srinath, Murphy TX 75094 (US); HAROUN, Baher, Allen TX 75013 (US); SEOK, Eunyoung, Plano TX 75023 (US)
(74) Representative: Zeller, Andreas
(86) International application number: PCT/US2012/038486
(87) International publication number: WO 2012/158993

(56) References cited:
- US-A1- 2006 017 496
- US-A1- 2010 309 594
- US-B1- 6 822 518
- US-B2- 6 538 497
- US-B2- 7 612 616
- US-B2- 7 839 129

## Description

This relates generally to regulating power supplies and, more particularly, to compensating for supply transients in duty cycle systems.

### BACKGROUND

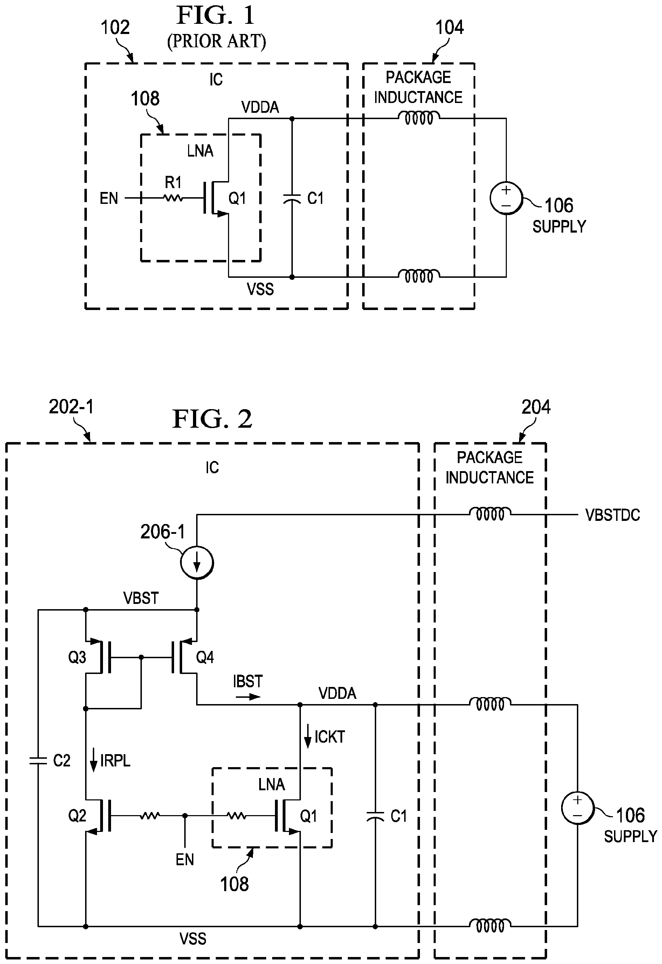

Turning to FIG. 1, an example of a conventional integrated circuit (IC) 102 can be seen. This IC 102 generally includes an input circuit (which is a low noise amplifier or LNA 108 for this example) that has a large time varying current consumption. As shown in this example, the LNA 108 is represented by NMOS transistor Q1 and resistor R1 that is coupled between two supply rails VDDA and VSS (which are coupled to supply 106) and that receives enable signal EN. Typically, the enable signal EN is comprised of a pulse stream (which is typically on 1ns out of every 10ns). In operation, LNA 108 (as well as other input circuits) can suffer from losses due to resistive voltage drops as well as voltage changes due to the package inductances 104, and because the of these package inductances 104, the LNA 108 (or other circuitry) should be activated for a period that is longer than a very short period of time (i.e., 10ns) provided by enable signal EN to allow the supply transients to settle. Capacitor C1 is often used to perform static decoupling, but, for many applications, this is insufficient. Therefore, there is a need for a method and/or apparatus to perform active decoupling.

Some other conventional circuits are: U.S. Patent No. 6,414,553; U.S. Patent No. 7,084,706; U.S. Patent No. 7,839,129; U.S. Patent Pre-Grant Publ. No. 2009/0066162; and Pant et al., "A Charge-Injection Based Active-Decoupling Technique for Inductive-Supply-Noise Suppression," IEEE Intl. Solid-State Circuits Conf. 2008, Digest of Technical Papers, pp 416, 417, and 624, Feb. 3-7, 2008.

US2006/017496 relates to a step down converter.

### SUMMARY

The invention is defined by the features of the appended claims.

### BRIEF DESCRIPTION OF THE DRAWINGS

Embodiments are described with reference to accompanying drawings, wherein:
FIG. 1 is a diagram of an example of a conventional IC; and
FIGS. 2-4 are diagrams of example of an IC In an embodiment.

### DETAILED DESCRIPTION OF EXAMPLE EMBODIMENTS

FIG. 2 illustrates an example of an IC. As shown, IC 202-1 has similar components to IC 102, but IC 202-1 also includes a boost circuit that is able to supply current from a supply VBSTDC (which either on-chip or off-chip, but is shown as being off-chip for this example) to compensate for the voltage changes due to the package inductance 204 (usually bondwire inductances) and resistive voltage drops. Supply VBSTDC also generally supplies a higher voltage than supply 106. To accomplish this, a replica circuit (i.e., transistor Q2) is able to source a current from current source 206-1 (which can be a generally constant current source) that is a replica IRPL of the current ICKT sourced by the input circuit (i.e., LNA 108). Typically, transistor Q2 can be between about 1 to N times the size of the transistor receiving the enable signal EN, such as transistor Q1, so that it can have the same or scaled duty cycle current as, for example, transistor Q1 without high frequency signal content. This replica current IRPL can be between 1 and 1/N of the current ICKT sourced by the input circuit (i.e., LNA 108), and this replica current IRPL can be mirrored through a current mirror (i.e., transistors Q3 and Q4) to generate a boost current IBST. As a result of this configuration, the supply 106 supplies a current that is the difference between the currents IBST and ICKT (which is typically much smaller than current ICKT). Additionally, to compensate for any ripple on rail VBST, capacitor C2 is provided (which can be varied in size depending on the desired headroom and ripple amplitude). Transistors Q2 through Q4 may also be NMOS or PMOS transistors or may be comprised of bipolar transistors.

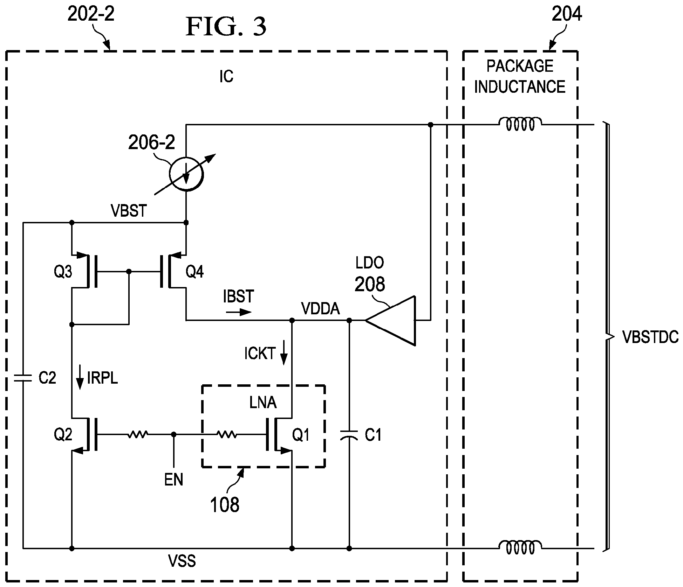

As an alternative, supply 106 can be eliminated in another configuration shown in FIG. 3. Because supply 106 supplies a small current, an on-chip low dropout regulator (LDO) 208 can be used instead to supply this small current (which is the difference between the currents IBST and ICKT). However, because the LDO 208 affects the power supplied by supply VBSTDC, an adjustable current source 206-2 should be used instead of the generally constant current source 206-1 to compensate for the changes due to the LDO 208. Low frequency control loops can be used to control or adjust the current source 206-2. In addition to the LDO 208, a regulator (not shown and which is separate from LDO 208) can be provided to regulate rail VBST.

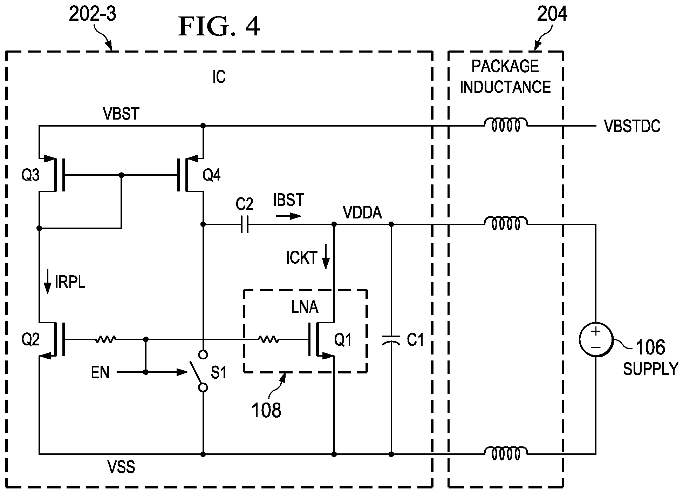

As another alternative, capacitor C2 can be used as a boost capacitor as shown in FIG. 4. Here, a switch S1 is coupled between the drain (or collector) and rail VSS, and capacitor C2 is coupled between the drain (or collector) and rail VDDA. The switch S1 is generally controlled by an inverse of the enable signal EN. When the enable signal EN is logic low or "0," the switch S1 is closed so that charge from rail VDDA can be accumulated on capacitor C2, and when the enable signal EN is logic high or "1" (i.e., during a pulse), the switch S1 is open so that capacitor C2 can boost the current supplied by the current mirror (i.e., transistors Q3 and Q4). By using this arrangement, the current source 206-1 or 206-2 can be eliminated and the supply VBSTDC can supply the same voltage as supply 106, but these supplies VBSTDC and 106 should not share the same bondwire in order to separate the parasitic inductances.

By using the ICs 200-1 to 200-3 several advantages can be realized. Since each IC 200-1 to 200-3 employs a feedforward compensation mechanism, current can be provided on-demand by the input circuit (i.e., LNA 108), avoiding detection or feedback schemes at frequency that would otherwise be employed. Additionally, any regulations loop that may be employed with ICs 200-1 to 200-3 can operate at low frequency.

Those skilled in the art will appreciate that modifications may be made to the described embodiments, and also that many other embodiments are possible, without departing from the scope of the claimed invention.

## Claims

1. An apparatus comprising:
a first supply rail (VDDA);
a second supply rail (VSS);
a third supply rail (VBST);
a first capacitor (C1) that is coupled between the first and second supply rails (VDDA, VSS);
a second capacitor (C2) that is coupled to at least one of the first and third supply rails (VDDA, VBST);
an input circuit (108) that is coupled between the first and second supply rails (VDDA, VSS) and that is configured to receive an enable signal (EN), wherein the input circuit (108) is configured to source a first current (ICKT);
a replica circuit that is configured to receive the enable signal (EN) and that is configured to generate a second current (IRPL) that is a replica of the first current (ICKT), wherein the replica circuit comprises a first transistor (Q2) having a first electrode, a second electrode, and a control electrode, wherein the second electrode of the first transistor (Q2) is coupled to the second supply rail (VSS), and wherein the control electrode of the first transistor (Q2) is configured to receive the enable signal (EN); and
a current mirror (Q3, Q4) that is coupled to the third supply rail (VBST), the first supply rail (VDDA), and the first electrode of the first transistor (Q2), the current mirror (Q3, Q4) configured to mirror the second current (IRPL) and to provide a third current (IBST) to the input circuit (108).

2. The apparatus of Claim 1, wherein the current mirror further comprises:
a second transistor (Q3) that is coupled between the third supply rail (VBST) and the first electrode of the first transistor (Q2), wherein the second transistor (Q3) has a control electrode, and wherein the second transistor (Q3) is diode-connected; and
a third transistor (Q4) having a control electrode, wherein the third transistor (Q4) is coupled between the first and third supply rails (VDDA, VBST) and is coupled to the control electrode of the second transistor (Q3) at its control electrode.

3. The apparatus of Claim 2, wherein the second capacitor (C2) is coupled between the second and third supply rails (VSS, VBST), and wherein the apparatus further comprises a current source (206) that is coupled to the third supply rail (VBST).

4. The apparatus of Claim 3, wherein the current source (206) further comprises an adjustable current source.

5. The apparatus of Claim 4, wherein the apparatus further comprises a low dropout regulator (LDO) that is coupled to the first and third supply rails (VDDA, VBST).

6. The apparatus of Claim 5, wherein the input circuit (108) further comprises a low noise amplifier (LNA).

7. The apparatus of Claim 2, wherein the second capacitor (C2) is coupled between the third transistor (Q4) and the first supply rail (VDDA).

8. The apparatus of Claim 7, wherein the apparatus further comprises a switch (S1) that is coupled between the third transistor (Q4) and the second supply rail (VSS), wherein the switch (S1) is configured to be controlled by an inverse of the enable signal (EN).

9. The apparatus of Claim 1, wherein the first transistor (Q2) is a MOS transistor that is coupled to the second supply rail (VSS) at its source and that is configured to receive the enable signal (EN) at its gate.

10. A method comprising:
in response to an enable signal replicating a first current (ICKT) that is sourced by an input circuit (108) so as to generate a second current (IRPL);
mirroring the second current (IRPL) so as to provide a third current (IBST) to the input circuit (108) from a first supply (VBSTDC) that is coupled to a third supply rail (VBST); and
providing a fourth current from a first supply rail (VDDA) that is coupled to a second supply (106), wherein the fourth current is the difference between the third and first currents (ICKT, IBST).

11. The method of Claim 10, wherein the method further comprises compensating for a ripple on the third supply rail (VBST).

12. The method of Claim 11, wherein the method further comprises providing a constant current to the third supply rail (VBST).

13. The method of Claim 11, wherein the second supply (106) further comprises an LDO (208) that is coupled to the first supply (VBSTDC).

14. The method of Claim 13, wherein the method further comprises adjusting a fifth current provided to the third supply rail (VBST) based at least in part on an output of the LDO (208).

15. The method of Claim 10, wherein the step of providing further comprises:
coupling a second capacitor (C2) between the first supply rail (VDDA) and a second supply rail (VSS) during a first interval so as to charge the second capacitor (C2); and
coupling the second capacitor (C2) between the third supply rail (VBST) and the input circuit (108) during a second interval.

## Patentansprüche

1. Vorrichtung, die Folgendes umfasst:
eine erste Versorgungsschiene (VDDA);
eine zweite Versorgungsschiene (VSS);
eine dritte Versorgungsschiene (VBST);
einen ersten Kondensator (C1), der zwischen die erste und die zweite Versorgungsschiene (VDDA, VSS) gekoppelt ist;
einen zweiten Kondensator (C2), der an die erste und/oder die dritte Versorgungsschiene (VDDA, VBST) gekoppelt ist;
eine Eingangsschaltung (108), die zwischen die erste und die zweite Versorgungsschiene (VDDA, VSS) gekoppelt ist und die konfiguriert ist, ein Aktivierungssignal (EN) zu empfangen, wobei die Eingangsschaltung (108) konfiguriert ist, einen ersten Strom (ICKT) zu beziehen;
eine Kopierschaltung, die konfiguriert ist, das Aktivierungssignal (EN) zu empfangen, und die konfiguriert ist, einen zweiten Strom (IRPL) zu erzeugen, der eine Kopie des ersten Stroms (ICKT) ist, wobei die Kopierschaltung einen ersten Transistor (Q2) mit einer ersten Elektrode, einer zweiten Elektrode und einer Gegenelektrode umfasst, wobei die zweite Elektrode des ersten Transistors (Q2) an die zweite Versorgungsschiene (VSS) gekoppelt ist und wobei die Gegenelektrode des ersten Transistors (Q2) konfiguriert ist, das Aktivierungssignal (EN) zu empfangen; und
einen Stromspiegel (Q3, Q4), der an die dritte Versorgungsschiene (VBST), die erste Versorgungsschiene (VDDA) und die erste Elektrode des ersten Transistors (Q2) gekoppelt ist, wobei der Stromspiegel (Q3, Q4) konfiguriert ist, den zweiten Strom (IRPL) zu spiegeln und einen dritten Strom (IBST) an die Eingangsschaltung (108) zu liefern.

2. Vorrichtung nach Anspruch 1, wobei der Stromspiegel ferner Folgendes umfasst:
einen zweiten Transistor (Q3), der zwischen die dritte Versorgungsschiene (VBST) und die erste Elektrode des ersten Transistors (Q2) gekoppelt ist, wobei der zweite Transistor (Q3) eine Steuerelektrode besitzt und wobei der zweite Transistor (Q3) diodenverbunden ist; und
einen dritten Transistor (Q4) mit einer Steuerelektrode, wobei der dritte Transistor (Q4) zwischen die erste und die dritte Versorgungsschiene (VDDA, VBST) gekoppelt ist und an seiner Steuerelektrode an die Steuerelektrode des zweiten Transistors (Q3) gekoppelt ist.

3. Vorrichtung nach Anspruch 2, wobei der zweite Kondensator (C2) zwischen die zweite und die dritte Versorgungsschiene (VSS, VBST) gekoppelt ist und wobei die Vorrichtung ferner eine Stromquelle (206) umfasst, die an die dritte Versorgungsschiene (VBST) gekoppelt ist.

4. Vorrichtung nach Anspruch 3, wobei die Stromquelle (206) ferner eine einstellbare Stromquelle umfasst.

5. Vorrichtung nach Anspruch 4, wobei die Vorrichtung ferner einen Regler mit geringem Abfall (LDO) umfasst, der an die erste und die dritte Versorgungsschiene (VDDA, VBST) gekoppelt ist.

6. Vorrichtung nach Anspruch 5, wobei die Eingangsschaltung (108) ferner einen rauscharmen Verstärker (LNA) umfasst.

7. Vorrichtung nach Anspruch 2, wobei der zweite Kondensator (C2) zwischen den dritten Transistor (Q4) und die erste Versorgungsschiene (VDDA) gekoppelt ist.

8. Vorrichtung nach Anspruch 7, wobei die Vorrichtung ferner einen Schalter (S1) umfasst, der zwischen den dritten Transistor (Q4) und die zweite Versorgungsschiene (VSS) gekoppelt ist, wobei der Schalter (S1) konfiguriert ist, durch einen Kehrwert des Aktivierungssignals (EN) gesteuert zu werden.

9. Vorrichtung nach Anspruch 1, wobei der erste Transistor (Q2) ein MOS-Transistor ist, der an seinem Source-Anschluss an die zweite Versorgungsschiene (VSS) gekoppelt ist und der konfiguriert ist, an seinem Gate-Anschluss das Aktivierungssignal (EN) zu empfangen.

10. Verfahren, das Folgendes umfasst:
als Reaktion auf ein Aktivierungssignal, das einen ersten Strom (ICKT) kopiert, der durch eine Eingangsschaltung (108) bezogen wird, um einen zweiten Strom (IRPL) zu erzeugen;
Spiegeln des zweiten Stroms (IRPL), um einen dritten Strom (IBST) von einer ersten Versorgung (VBSTDC), die an eine dritte Versorgungsschiene (VBST) gekoppelt ist, an die Eingangsschaltung (108) zu liefern; und
Liefern eines vierten Stroms von einer ersten Versorgungsschiene (VDDA), die an eine zweite Versorgung (106) gekoppelt ist, wobei der vierte Strom der Unterschied zwischen dem dritten und dem ersten Strom (ICKT, IBST) ist.

11. Verfahren nach Anspruch 10, wobei das Verfahren ferner umfasst, eine Wellenform auf der dritten Versorgungsschiene (VBST) zu kompensieren.

12. Verfahren nach Anspruch 11, wobei das Verfahren ferner umfasst, einen konstanten Strom an die dritte Versorgungsschiene (VBST) zu liefern.

13. Verfahren nach Anspruch 11, wobei die zweite Versorgung (106) ferner einen LDO (208) umfasst, der an die erste Versorgung (VBSTDC) gekoppelt ist.

14. Verfahren nach Anspruch 13, wobei das Verfahren ferner umfasst, zumindest teilweise anhand einer Ausgabe des LDO (208) einen fünften Strom anzupassen, der an die dritte Versorgungsschiene (VBST) geliefert wird.

15. Verfahren nach Anspruch 10, wobei der Schritt des Lieferns ferner Folgendes umfasst:
Koppeln eines zweiten Kondensators (C2) während eines ersten Intervalls zwischen die erste Versorgungsschiene (VDDA) und eine zweite Versorgungsschiene (VSS), um den zweiten Kondensator (C2) zu laden; und
Koppeln des zweiten Kondensators (C2) während eines zweiten Intervalls zwischen die dritte Versorgungsschiene (VBST) und die Eingangsschaltung (108).

## Revendications

1. Appareil comprenant :
un premier rail d'alimentation (VDDA) ;
un deuxième rail d'alimentation (VSS) ;
un troisième rail d'alimentation (VBST) ;
un premier condensateur (C1) qui est couplé entre le premier et le deuxième rail d'alimentation (VDDA, VSS) ;
un deuxième condensateur (C2) qui est couplé à au moins un des premier et troisième rails d'alimentation (VDDA, VBST) ;
un circuit d'entrée (108) qui est couplé entre le premier et le deuxième rail d'alimentation (VDDA, VSS) et qui est configuré pour recevoir un signal d'activation (EN), le circuit d'entrée (108) étant configuré pour introduire un premier courant (ICKT) ;
un circuit réplique qui est configuré pour recevoir le signal d'activation (EN) et qui est configuré pour générer un deuxième courant (IRPL) qui est une réplique du premier courant (ICKT), le circuit réplique comprenant un premier transistor (Q2) ayant une première électrode, une deuxième électrode et une électrode de commande, la deuxième électrode du premier transistor (Q2) étant couplée au deuxième rail d'alimentation (VSS), et l'électrode de commande du premier transistor (Q2) étant configurée pour recevoir le signal d'activation (EN) ; et
un miroir de courant (Q3, Q4) qui est couplé au troisième rail d'alimentation (VBST), au premier rail d'alimentation (VDDA) et à la première électrode du premier transistor (Q2), le miroir de courant (Q3, Q4) étant configuré pour copier le deuxième courant (IRPL) et pour fournir un troisième courant (IBST) au circuit d'entrée (108).

2. Appareil de la revendication 1, dans lequel le miroir de courant comprend en outre :
un deuxième transistor (Q3) qui est couplé entre le troisième rail d'alimentation (VBST) et la première électrode du premier transistor (Q2), le deuxième transistor (Q3) ayant une électrode de commande, et le deuxième transistor (Q3) étant connecté par diode ; et
un troisième transistor (Q4) ayant une électrode de commande, le troisième transistor (Q4) étant couplé entre le premier et le troisième rail d'alimentation (VDDA, VBST) et étant couplé à l'électrode de commande du deuxième transistor (Q3) à son électrode de commande.

3. Appareil de la revendication 2, le deuxième condensateur (C2) étant couplé entre le deuxième et le troisième rail d'alimentation (VSS, VBST), et l'appareil comprenant en outre une source de courant (206) qui est couplée au troisième rail d'alimentation (VBST).

4. Appareil de la revendication 3, dans lequel la source de courant (206) comprend en outre une source de courant réglable.

5. Appareil de la revendication 4, l'appareil comprenant en outre un régulateur à faible chute de tension (LDO) qui est couplé aux premier et troisième rails d'alimentation (VDDA, VBST).

6. Appareil de la revendication 5, dans lequel le circuit d'entrée (108) comprend en outre un amplificateur à faible bruit (LNA).

7. Appareil de la revendication 2, dans lequel le deuxième condensateur (C2) est couplé entre le troisième transistor (Q4) et le premier rail d'alimentation (VDDA).

8. Appareil de la revendication 7, l'appareil comprenant en outre un commutateur (S1) qui est couplé entre le troisième transistor (Q4) et le deuxième rail d'alimentation (VSS), le commutateur (S1) étant configuré pour être contrôlé par un inverse du signal d'activation (EN).

9. Appareil de la revendication 1, dans lequel le premier transistor (Q2) est un transistor MOS qui est couplé au deuxième rail d'alimentation (VSS) à sa source et qui est configuré pour recevoir le signal d'activation (EN) à sa grille.

10. Procédé comprenant :
en réponse à un signal d'activation, la réplication d'un premier courant (ICKT) qui est introduit par un circuit d'entrée (108) de manière à générer un deuxième courant (IRPL) ;
la copie du deuxième courant (IRPL) de manière à fournir un troisième courant (IBST) au circuit d'entrée (108) depuis une première alimentation (VBSTDC) qui est couplée à un troisième rail d'alimentation (VBST) ; et
la fourniture d'un quatrième courant depuis un premier rail d'alimentation (VDDA) qui est couplé à une deuxième alimentation (106), le quatrième courant étant la différence entre le troisième et le premier courant (ICKT, IBST).

11. Procédé de la revendication 10, le procédé comprenant en outre la compensation d'une ondulation sur le troisième rail d'alimentation (VBST).

12. Procédé de la revendication 11, le procédé comprenant en outre la fourniture d'un courant constant au troisième rail d'alimentation (VBST).

13. Procédé de la revendication 11, dans lequel la deuxième alimentation (106) comprend en outre un LDO (208) qui est couplé à la première alimentation (VBSTDC).

14. Procédé de la revendication 13, le procédé comprenant en outre le réglage d'un cinquième courant fourni au troisième rail d'alimentation (VBST) au moins en partie sur la base d'une sortie du LDO (208).

15. Procédé de la revendication 10, dans lequel l'étape de fourniture comprend en outre :
le couplage d'un deuxième condensateur (C2) entre le premier rail d'alimentation (VDDA) et un deuxième rail d'alimentation (VSS) pendant un premier intervalle de manière à charger le deuxième condensateur (C2) ; et
le couplage du deuxième condensateur (C2) entre le troisième rail d'alimentation (VBST) et le circuit d'entrée (108) pendant un deuxième intervalle.
